# EUROPÄISCHE PATENTSCHRIFT

(11) **EP 2 526 747 B1**
(45) Veröffentlichungstag und Bekanntmachung des Hinweises auf die Patenterteilung: **14.09.2016**
(21) Anmeldenummer: 11700643.7
(22) Anmeldetag: 12.01.2011
(51) Int. Cl.: H05K 7/20

(54) **REGELUNGSVERFAHREN EINER KÜHLANLAGE**
METHOD FOR REGULATING A COOLING SYSTEM
PROCÉDÉ DE RÉGULATION D'UNE INSTALLATION DE REFROIDISSEMENT

(30) Priorität: 21.01.2010 DE 102010005192
(43) Veröffentlichungstag der Anmeldung: 28.11.2012
(73) Patentinhaber: RITTAL GmbH & Co. KG, 35745 Herborn (DE)
(72) Erfinder: SAAL, Helmut, 57632 Reiferscheid (DE); NICOLAI, Michael, 35466 Allertshausen (DE)
(74) Vertreter: Angerhausen, Christoph
(86) Internationale Anmeldenummer: PCT/EP2011/050328
(87) Internationale Veröffentlichungsnummer: WO 2011/089051

(56) Entgegenhaltungen:
- WO-A1-2009/123617
- US-A1- 2003 147 214
- US-A1- 2008 092 577

## Beschreibung

Die Erfindung bezieht sich auf ein Regelungsverfahren einer Kühlanlage zum Kühlen von in Schaltschränken oder Racks aufgenommenen elektrischen Einbaugeräten mittels diesen zugeordneter Kühleinheiten, die von einem mittels einer Kühleinrichtung der Kühlanlage herunter gekühlten flüssigen Kühlmedium durchströmt werden, wobei eine Kühlleistung zum Kühlen der Einbaugeräte nach Vorgabe durch eine Hauptführungsgröße einregelbar ist, sowie auf eine Anordnung zur Durchführung des Verfahrens.

Ein derartiges Regelungsverfahren geht aus der EP 1 604 262 B1 hervor, wobei eine Kühlflüssigkeit in einer Rückkühleinrichtung auf eine vorgegebene Temperatur heruntergekühlt wird. Von der Kühlflüssigkeit durchströmte Kühleinheiten sind dabei den einzelnen elektrischen Einbaugeräten zugeordnet. Oft sind Schaltschränke oder Racks dicht bepackt mit Einbaugeräten, insbesondere Servern, so dass zur Kühlung der Einbaugeräte ein hoher Kühlleistungsbedarf besteht, der einen hohen Aufwand an Kühlenergie erfordert. Zur Energieeinsparung wird ein möglichst effizientes Kühlkonzept angestrebt.

In der DE 10 2006 051 904 A1 ist eine Kühlanlage mit Kühleinheiten zum Einblasen von Kühlluft im Bereich von Einbaugeräten eines Schaltschranks oder Racks gezeigt, wobei die Kühleinheiten von Kühlwasser durchströmt werden. Die Regelung der Vorlauftemperatur des Kühlwassers erfolgt mittels einer Regeleinrichtung. Die Förderleistung einer Pumpeinrichtung lässt sich dabei in Abhängigkeit von der Rücklaufund/oder der Vorlauftemperatur des Kühlwassers regeln, um die erforderliche Menge an Kühlwasser und Kühlleistung bereit zu stellen. Die Kühlanlage umfasst einen externen Kühlkreislauf. Auch mit einem derartigen Aufbau der Kühlanlage lässt sich eine hohe Kühlleistung für elektrische Einbaugeräte, wie z. B. Server, bereitstellen, wobei ebenfalls ein entsprechender Energieaufwand erforderlich ist.

Eine weitere Schaltschrankklimatisierungsanlage mit verschiedenen Kühlkomponenten und einer Regelungseinrichtung ist in der DE 196 15 469 C2 angegeben. Auch aus der DE 297 24 561 U1 und der DE 101 08 599 C2 gehen Klimatisierungseinrichtungen bzw. Kühlanlagen für in Schaltschränke oder Racks eingebaute elektrische Einbaugeräte sowie Steuerungs- und Regelungskonzepte hervor.

In der DE 603 05 436 T2 ist ein Verfahren und ein System zum Kühlen eines Raumes mit einer Mehrzahl von Computersystemen angegeben, bei dem eine reihe von Verdampfereinheiten vorhanden sind und Temperaturen an einer oder mehreren Stellen in dem Raum erfasst werden, um eine Temperatursteuerung der Luft durchzuführen. Eine energieeffiziente Kühlung ist auch hierbei schwierig.

Die DE 100 29 664 A1 zeigt ein Klimasystem für zentrale Aufstellungsräume von Nachrichten- und Rundfunktechnik, wobei die Anzahl von Kälteerzeugern gemäß n+1 festgelegt ist und ein Freikühlbetrieb genannt ist.

Die Dokumente WO 2009/123617 A1 und US 2003/147214 A1 offenbaren Regelungsverfahren für Kühlanlagen, bei denen eine Vorlauftemperatur eines flüssigen Kühlmediums nach Vorgabe einer aus dem Kühlleistungsbedarf von Einbaugeräten gebildeten Hauptführungsgrösse geregelt wird.

Der Erfindung liegt die Aufgabe zugrunde, ein Regelungsverfahren einer Kühlanlage zum Kühlen von in Schaltschränken oder Racks aufgenommenen elektrischen Einbaugeräten sowie eine entsprechende Anordnung bereit zu stellen, mit dem/der eine möglichst energieeffiziente, umweltschonende Kühlung erreicht wird.

Diese Aufgabe wird mit den Merkmalen des Anspruches 1 gelöst. Hierbei ist vorgesehen, dass die Vorlauftemperatur variabel entsprechend einem Kühlleistungsbedarf im Bereich der Einbaugeräte angepasst wird, wobei aus dem Kühlleistungsbedarf im Bereich der Einbaugeräte die Hauptführungsgröße gebildet wird.

Mit dieser Vorgehensweise gelingt eine auf den jeweiligen Kühlleistungsbedarf genau abstimmbare Bereitstellung von Kühlleistung, wobei auch eine optimierte Anpassung an äußere Gegebenheiten ermöglicht wird. So kann beispielsweise bei Serverschränken die Server-Zuluft-Temperatur konstant auf einem vom Anwender gewünschten Wert gehalten werden. Dieser Wert bzw. die Hauptführungsgröße kann je nach Systemzustand dynamisch verändert werden. Die Kühlmittelquellen sind möglichst umweltschonend nutzbar. Dabei kann nach wie vor zur schnellen Reaktion auf Kühlerfordernisse z. B. eine Kühlmittelmenge durch Ansteuern von Pumpen mit sich ändernder Pumpleistung variiert werden. Die variable adaptive Anpassung der Vorlauftemperatur ergibt insgesamt eine effiziente Energienutzung. Eine Kühleinheit kann jeweils einem oder mehreren Einbaugeräten zugeordnet sein.

Eine vorteilhafte Ausgestaltung des Verfahrens besteht darin, dass die Kühleinrichtung eine Rückkühleinrichtung aufweist, mit der zumindest zum Teil und/oder zumindest zeitweise die Kühlung des Kühlmediums erfolgt.

Bei der Durchführung des Regelungsverfahrens wird die Hauptführungsgröße aus einer Einblastemperatur von Einblasluft in dem Bereich der Einbaugeräte, beispielsweise einer 19"-Einbauebene, bestimmt, wobei die Einblastemperatur von der Kühlanlage auf vorgegebenem Niveau gehalten wird.

Dabei weist die Kühlanlage mehrere im Bereich der Einbaugeräte angeordnete Kühleinheiten mit Ventilatoren auf, die die Einblasluft erzeugen, und die vorgegebenen oder erzeugten Einblastemperaturwerte aller Kühleinheiten werden auf den kleinsten oder gegebenenfalls gleichen Einblastemperaturwert miteinander verglichen als Einblastemperatur wird der kleinste Einblastemperaturwert zugrunde gelegt, womit die Hauptführungsgröße bestimmt und die Wasservorlauftemperatur angepasst wird. Ein für die Kühlung günstiges Regelungskonzept besteht darin, dass in der Regelstrecke jede Kühleinheit mit aktivem Vorgabewert betrachtet wird, dass ein Vergleich des Temperaturunterschieds zwischen Vorgabewert und Istwert jeder Kühleinheit erfolgt und dass eine Regelabweichung für die Regelung aus dem momentan größten Temperaturunterschied der Kühleinheiten hergeleitet wird.

Gute Anpassungsmöglichkeiten an unterschiedliche Kühlanforderungen werden ferner dadurch erreicht, dass eine PID-Regelung durchgeführt wird.

Zu einer vorteilhaften Regelung der Kühlung tragen ferner die Maßnahmen bei, dass bei der PID-Regelung als D-Anteil der Regelabweichung eine zeitliche Änderung der Regelabweichung betrachtet wird und dass dann, wenn die zeitliche Änderung eine vorgegebene Schwelle überschreitet, die Vorlauftemperatur angepasst wird. Zusätzlich wird die Regelung durch Änderung der Pumpleistung entsprechend der Leistungsanforderung vorgenommen.

Eine stabile Regelung mit guter Nachführbarkeit wird dadurch unterstützt, dass die Vorlauftemperatur dadurch angepasst wird, dass ein Sollwert der Vorlauftemperatur geändert und die Vorlauftemperatur an den geänderten Sollwert der Vorlauftemperatur angepasst wird.

Zu einer umweltschonenden Energienutzung tragen die Maßnahmen bei, dass die Kühlung des Kühlmediums zumindest zeitweise zum Teil oder vollständig mittels einer Freikühleinrichtung oder einer Erdkälteeinrichtung oder einer Absorptionskälteeinrichtung vorgenommen wird.

Dabei wird das Regelungskonzept dadurch begünstigt, dass ein Freikühlungssollwert aus dem Sollwert der Vorlauftemperatur minus einer bekannten Temperaturdifferenz der Freikühleinrichtung berechnet wird, und ferner dadurch, dass der Freikühlungssollwert adaptiv entsprechend dem Kühlleistungsbedarf angepasst wird.

Eine weitere vorteilhafte Ausgestaltung des Verfahrens besteht darin, dass die Hauptführungsgröße entsprechend einer möglichst energieeffizienten Kühlung der Einbaugeräte, insbesondere Server, bestimmt wird, wobei die Verlustleistung der Einbaugeräte im Bereich zulässiger Betriebstemperaturen nach Maßgabe eines möglichst energieeffizienten Betriebs des Gesamtsystems einschließlich der Kühlanlage kalkuliert wird. Mit diesen Maßnahmen wird auch der Betrieb der Einbaugeräte, beispielsweise Server, mit in die Energiebilanz des Gesamtsystems einschließlich der Kühlanlage einbezogen und der zulässige Temperaturbereich für einen sicheren Betrieb der Einbaugeräte genutzt. Beispielsweise können Server-Lüfter, die in dem Gehäuse der Server von Hause aus eingebaut sind, mit geringerer oder höherer Leistung im Zusammenspiel mit der von der Kühlanlage bereit gestellten Kühlleistung, d. h. der von der Kühlanlage gelieferten Kühlluft betrieben werden mit der Maßgabe, dass die Gesamtenergiebilanz optimiert wird. Unter gewissen Bedingungen kann nämlich eine erhöhte Leistungsaufnahme der Server bei höherer Zuluft-temperatur durch die Kühlanlage geringer ins Gewicht fallen als die im Bereich der Kühlanlage eingesparte Energie. Kann aber von der Kühlanlage Kühlluft z. B. bei niedriger Umgebungstemperatur über die Freikühleinrichtung günstig zur Verfügung gestellt werden, kann es besser sein, die Server bzw. Einbaugeräte stärker zu kühlen, damit diese bei möglichst geringer Verlustleistung betrieben werden können.

Die Erfindung wird nachfolgend anhand von Ausführungsbeispielen unter Bezugnahme auf die Zeichnungen näher erläutert. Es zeigen:
- Fig. 1: eine schematische Darstellung einer Kühlanlage mit Rückkühleinrichtung, Freikühleinrichtung und mehreren Kühleinheiten,
- Fig. 2: eine Darstellung der Kühlanlage über eine Anzeigeeinrichtung mit Alphanumerikteil und Graphikteil,
- Fig. 3: eine Kühlanlage mit Kühleinheiten und verschiedenen Komponenten einer Kühlvorrichtung,
- Fig. 4: eine weitere Darstellung der Kühlanlage über die Anzeigeeinrichtung mit Alphanumerikteil und Graphikteil,
- Fig. 5: eine Steuereinheit der Kühlanlage,
- Fig. 6: einen Verlauf einer prozentualen Pumpenleistung der Rückkühleinrichtung über der Zeit,
- Fig. 7: einen Steuerteil der Kühlanlage unter Einbeziehung eines Freikühlerbetriebs,
- Fig. 8: verschiedene Skalen mit angezeigten Skalenwerten,
- Fig. 9: eine weitere graphische Darstellung der Kühlanlage über die Anzeigeeinrichtung,
- Fig. 10: Temperaturverläufe einer Vorlauftemperatur und einer Rücklauftemperatur sowie Sollwerten des Kühlmediums über der Zeit und
- Fig. 11: Verläufe einer mit der Rückkühleinrichtung produzierten Kühlleistung und einer in den Kühleinheiten benötigten Kühlleistung über der Zeit.

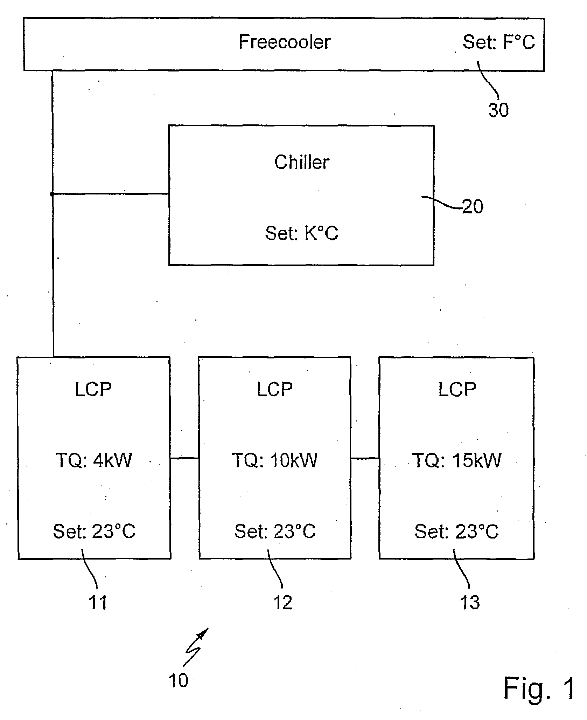

Fig. 1 zeigt schematisch als wesentliche Komponenten einer Kühlanlage zum Kühlen von in Schaltschränken oder Racks aufgenommenen elektrischen Einbaugeräten, wie z. B. Servern, eine im Bereich der Einbaugeräte angeordnete Kühlvorrichtung 10 mit mehreren, vorliegend einer ersten, zweiten und dritten Kühleinheit 11, 12, 13, eine Rückkühleinrichtung 20 für ein fluides, insbesondere flüssiges Kühlmedium, wie z. B. Wasser, sowie eine Freikühleinrichtung 30, mittels deren das Kühlmedium zusätzlich oder zeitweise auch vollständig unter Nutzung von Umgebungsluft heruntergekühlt werden kann, um über die Kühleinheiten 11, 12, 13 im Bereich der Einbaugeräte eine erforderliche Kühlleistung für den sicheren Betrieb der Einbaugeräte bereit zu stellen. Dabei können die Kühleinheiten 11, 12, 13 den Einbaugeräten jeweils 1:1 oder aber eine Kühleinheit mehreren Einbaugeräten zugeordnet sein und gleiche oder unterschiedliche Kühlleistungen und/oder gleiche oder unterschiedliche Temperatureinstellwerte, beispielsweise Einblastemperaturwerte, aufweisen, wobei die Kühlleistungen und Temperaturwerte vorgebbar sind. Die Vorlauftemperatur des den Kühleinheiten 11, 12, 13 zugeführten Kühlmediums wird entsprechend der im Bereich der Einbaugeräte erforderlichen Kühlleistung adaptiv angepasst, wobei vermittels der Freikühleinrichtung 30 die Kühlung im Rahmen der nutzbaren Kühlleistung aus der Umgebungsluft unterstützt wird und in diesem Rahmen ebenfalls eine adaptive Anpassung der von der Freikühleinrichtung 30 zugeführten Kühlleistung erfolgt.

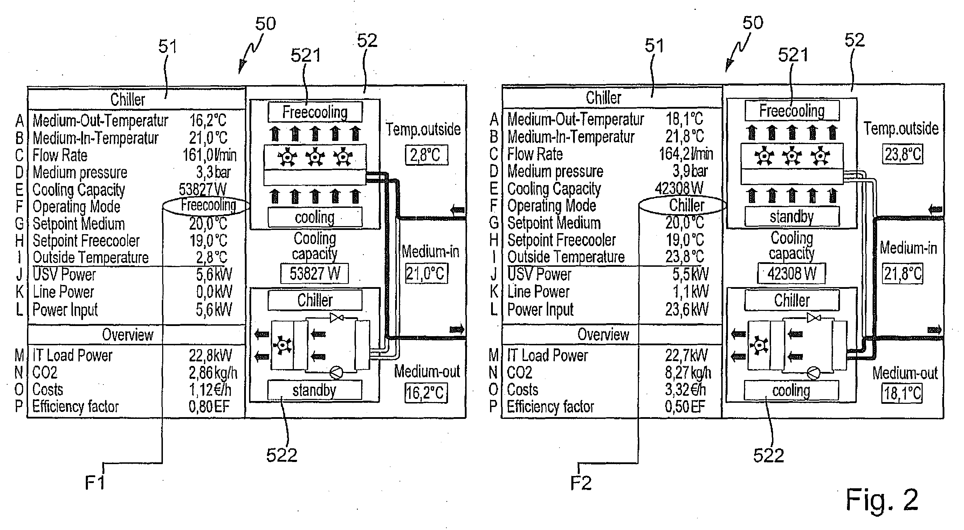

Fig. 2 zeigt zwei über eine Anzeigeeinrichtung 50 erzeugte Darstellungen zu zwei verschiedenen Betriebszuständen der Kühlanlage, wobei alphanumerische Informationen über einen Alphanumerikteil 51 und graphische Informationen über einen Graphikteil 52 der Anzeigeeinrichtung 50 dargeboten werden. Diese Darstellung ergibt eine bedienungsfreundliche Benutzerführung und soll nachfolgend zur näheren Erläuterung der Anordnung und des Regelungsverfahrens dienen.

Im Gegensatz zu bisherigen Regelungsverfahren von Kühlanlagen für in Schaltschränken oder Racks aufgenommenen elektrischen Einbaugeräten, die autark mit fest eingestellten Parametern arbeiten und, damit zusammenhängend, eine in gewissem Grad unnötige Bevorratung von Kühlleistung bedingen, wird bei vorliegendem Regelungsverfahren die Vorlauftemperatur entsprechend einem Kühlleistungsbedarf im Bereich der Einbaugeräte angepasst und die Hauptführungsgröße aus dem Kühlleistungsbedarf in dem Bereich der Einbaugeräte bestimmt. Bei dem Ausführungsbeispiel sind die von dem Kühlmedium durchströmten Kühleinheiten 11, 12, 13 mit Ventilatoren ausgerüstet, die in dem Bereich der Einbaugeräte, beispielsweise einer 19"-Einbauebene, für die Kühlung erforderliche Einblasluft erzeugen, wobei die Einblastemperatur von der Kühlanlage auf vorgegebenem Niveau gehalten wird. Die Solltemperaturen in den einzelnen Komponenten der Kühlanlage, insbesondere für die Vorlauftemperatur in der Rückkühleinrichtung 20 und eine weitere Solltemperatur in der gegebenenfalls vorhandenen Freikühleinrichtung 30, werden an den Kühlleistungsbedarf im Bereich der Einbaugeräte, bei vorliegendem Ausführungsbeispiel also auf die Einblastemperatur im Bereich der Einbaugeräte, adaptiv angepasst. Damit werden die Wasservorlauftemperatur sowie der weitere Sollwert der Freikühleinrichtung 30, nachfolgend als Freikühlungssollwert bezeichnet vom tatsächlichen Kühlleistungsbedarf bestimmt.

Fig. 2 zeigt in der linken Darstellung eine Betriebsbedingung bei niedriger Außentemperatur (z. B. 2,8° C), wobei die Freikühleinrichtung 30 effektiv nutzbar ist, wie durch die Betriebsart F, Freikühlen F1, hervorgehoben ist. Als weitere Angaben sind auf dem Alphanumerikteil 51 die Vorlauftemperatur A der Rückkühleinrichtung 20, die Rücklauftemperatur B, die Strömungsrate C, der Druck des Kühlmediums D, die Kühlkapazität bzw. Kühlleistung E, ein Sollwert des Kühlmediums bzw. Sollwert der Vorlauftemperatur G im Bereich der Rückkühleinrichtung 20, der Freikühlungssollwert H, die Außentemperatur I sowie elektrische Leistungswerte J, K, L dargestellt sowie ferner als Übersichtsinformationen die von Einbaugeräten verbrauchte Leistung M, die CO2 Erzeugung N, kosten pro Stunde O und ein Effizienzfaktor B angezeigt. Einige dieser Angaben mit entsprechender Bezeichnung finden sich auch in dem Graphikteil, wobei "Freecooling" sich auf die Freikühleinrichtung 30 und "Chiller" sich auf die Rückkühleinrichtung 20 beziehen.

In der rechten Darstellung der Fig. 2 liegen zu den vorstehend genannten Bezeichnungen geänderte Parameter bzw. Messwerte vor, wobei als Betriebsart F der Betrieb der Rückkühleinrichtung F2 angezeigt ist. Aus dem Vergleich beider Darstellungen geht auch hervor, dass sich der Betrieb der Kühlanlage und die Regelung adaptiv an vorliegende physikalische Gegebenheiten anpassen.

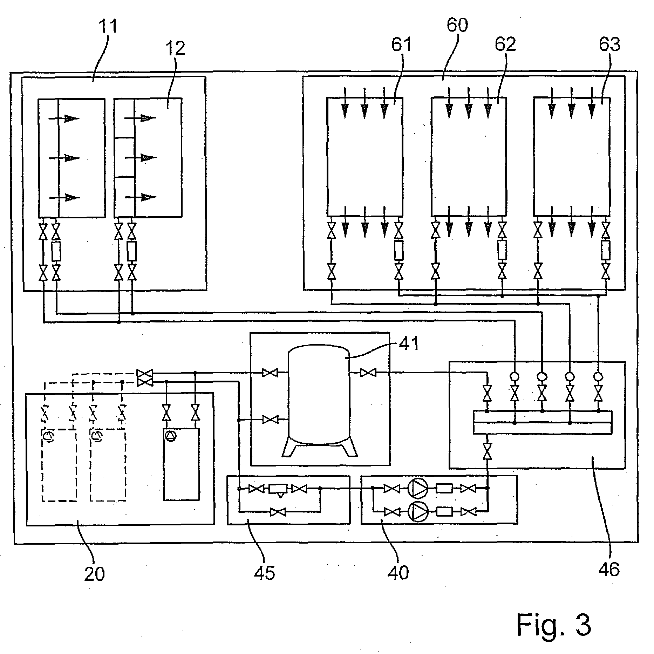

Fig. 3 zeigt ein Aufbaubeispiel mit der Kühlanlage, wobei außer der Rückkühleinrichtung 20 und zwei Kühleinheiten 11, 12 als weitere Komponenten der Kühlanlage Pumpen 40, ein Puffertank 41 für Kühlmedium, Filter 45, Verteiler 46 sowie eine UKS-Anordnung 60 mit mehreren UKS-Einrichtungen 61, 62, 63 gezeigt sind. Diese Anordnung mit der Kühlanlage ist gemäß vorliegend beschriebenem Regelungsverfahren betreibbar, wobei mittels der Pumpen 40 die pro Zeiteinheit geförderte Menge an Kühlmedium schnell entsprechend dem Kühlleistungsbedarf regelbar ist.

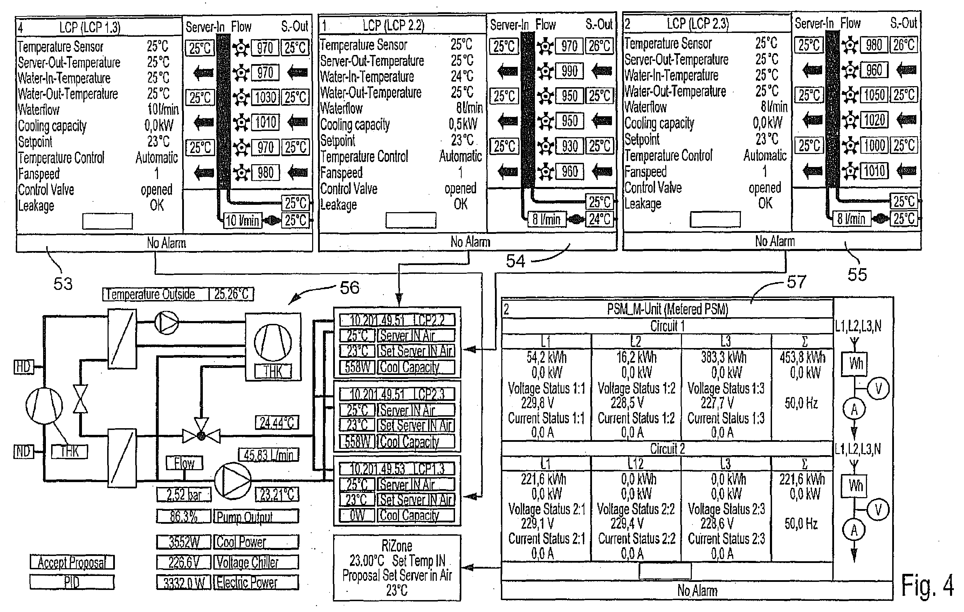

Fig. 4 zeigt eine Darstellung des Aufbaus und von Betriebsabläufen mit Messwerten und Parametern im Bereich der Kühleinheiten (LCP) 11, 12, 13 über die Anzeigeeinrichtung 50 mit dem Alphanumerikteil 51 und dem Graphikteil 52. Einzelne Bauteile der Kühlanlage, wie Ventilatoren, Pumpen, Wärmetauscher, Kompressor sind in der üblichen Symbolik eingezeichnet und an sich bekannt. Die Kühleinheiten 11, 12, 13 sind in den Kühleinheitanzeigen 53, 54, 55 dargestellt und auch in Kombination miteinander in einer Funktionsdarstellung 56, in der auch ein Anzeigebereich für eine übergeordnete Gerätezustandsanzeige 47 wiedergegeben ist, die von einer übergeordneten Steuerungsplattform (RiZone) erhalten wird und z. B. Parameter und Messwerte von elektrischen Verbrauchern umfasst. Fig. 4 veranschaulicht die Anordnung und das Regelungsverfahren.

Die vorgegebenen oder erzeugten Einblastemperaturwerte aller Kühleinheiten 11, 12, 13 werden auf den kleinsten Einblastemperaturwert verglichen, wobei auch mehrere gleiche Einblastemperaturwerte der Kühleinheiten vorliegen können. Als Einblastemperatur wird der kleinste Einblastemperaturwert zugrunde gelegt, woraus dann die Hauptführungsgröße bestimmt wird. Der Einblastemperaturwert hat damit direkten Einfluss auf den zu errechnenden, und damit adaptiv angepassten Sollwert der Wasservorlauftemperatur.

Als Regelstrecke wird jede Kühleinheit 11, 12, 13 betrachtet, deren Vorgabewert (Sollwert der Kühleinheit) als aktiv bestimmt wurde. Danach erfolgt ein Vergleich auf den Temperaturunterschied zwischen Vorgabewert und Istwert jeder Kühleinheit. Hieraus wird die momentan größte Regelabweichung abgeleitet, die dann als Regelabweichung für die Regelung zugrunde gelegt wird, wobei vorzugsweise eine PID-Regelung durchgeführt wird. Gleichzeitig wird, bei Anwendung einer PID-Regelung, der D-Anteil der Regelabweichung betrachtet, und dann, wenn die zeitliche Änderung eine vorgegebene Schwelle überschreitet, die Vorlauftemperatur neu angepasst. Dabei kann ein gegebenenfalls vorgesehener Gradienten-Abweichungsalarm genutzt werden.

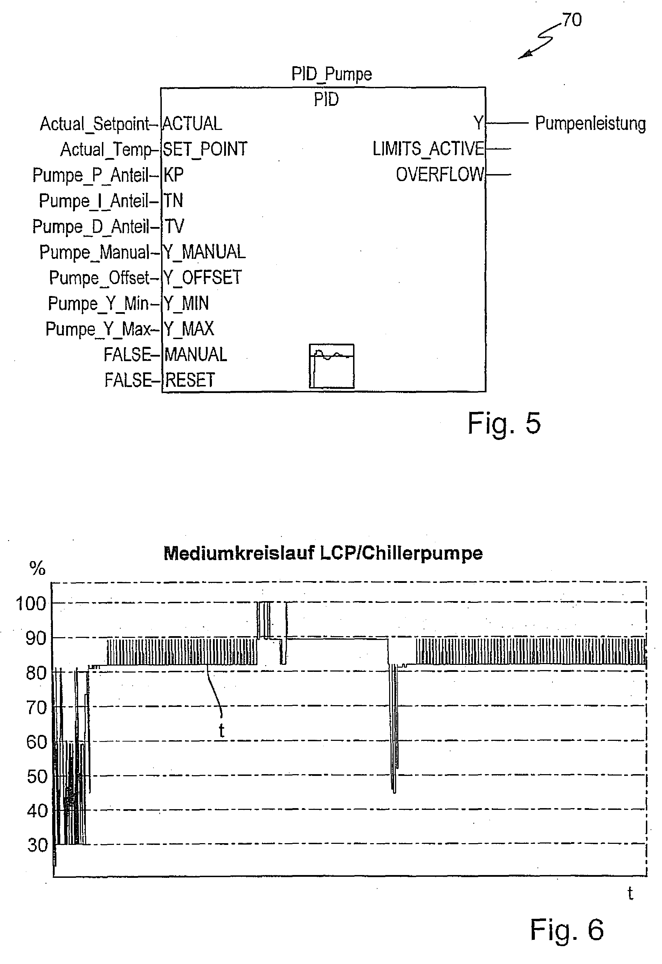

Um eine möglichst gut an gerätetechnische und physikalische Gegebenheiten angepasste, effiziente Regelung der bereitgestellten Kühlleistung zu erreichen, werden möglichst alle erfassten Messwerte zentral gesammelt. Hierzu ist vorteilhaft eine zentrale Steuereinheit 70 vorgesehen, wie in Fig. 5 gezeigt. Hierbei ist insbesondere auch die Ansteuerung der Pumpe zum Regeln der Pumpenleistung berücksichtigt. Aus dem Kühlleistungsbedarf bzw. Energiebedarf der einzelnen Kühleinheiten 11, 12, 13 wird ein Gesamtbedarf an Kühlleistung bzw. Kühlenergie ermittelt. Daraus wird eine notwendige Reserve der Pumpe(n) berechnet, um auf eine schwankende Lastanforderung elektrischer Verbraucher bzw. einen damit verbundenen erhöhten Kühlleistungsbedarf momentan schnell reagieren zu können. Gleichzeitig wird eine Anpassung der Vorlauftemperatur durch Absenken in Gang gesetzt, die wegen ihrer Trägheit erst im Nachgang verzögert zur Wirkung kommt. Fig. 6 zeigt beispielhaft einen zeitlichen Verlauf der prozentualen Pumpenleistung der Rückkühleinrichtung 20.

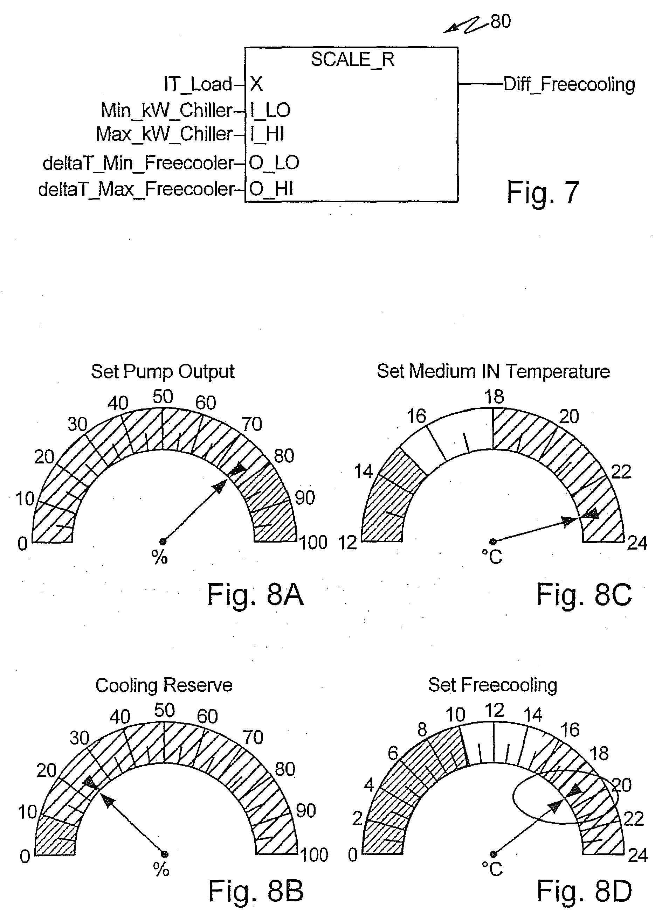

Der Freikühlungssollwert wird aus dem Sollwert der Vorlauftemperatur des Kühlmediums minus einer bekannten Temperaturdifferenz der Freikühleinrichtung 30 berechnet. Dann erfolgt eine adaptive Anpassung noch durch Messung der tatsächlichen Verlustleistung der elektrischen Einbaukomponenten, wie z. B. der Server, unter gleichzeitiger Berücksichtigung (Skalierung) der Temperaturdifferenz der Freikühleinrichtung 30. Ein Steuerteil 80 zur adaptiven Änderung des Freikühlungssollwerts ist in Fig. 7 dargestellt.

Da auf den tatsächlichen Kühlleistungsbedarf bzw. die betreffende Energieanforderung geregelt wird, kann sich im Einzelfall ein von der Regelungseinrichtung stark angehobener Freikühlungssollwert ergeben. Die Erhöhung des Freikühlungssollwerts führt zu mehr möglicher Bereitstellung von Kühlleistung durch die Freikühleinrichtung 30. Dies ergibt eine effizientere Energienutzung, da die Kühlung mittels einer Freikühleinrichtung nur etwa 10 bis 20 % der elektrischen Energie der Rückkühleinrichtung 20 benötigt.

Fig. 8 zeigt verschiedene Skalen mit über Zeiger angezeigten Skalenwerten, nämlich eine prozentuale Pumpenausgangsleistung 8A, eine Kühlreserve 8B, einen Einstellwert der Kühlmediumeingangstemperatur 8C und einen Einstellwert der Freikühlertemperatur (Freikühlungssollwert) 8D.

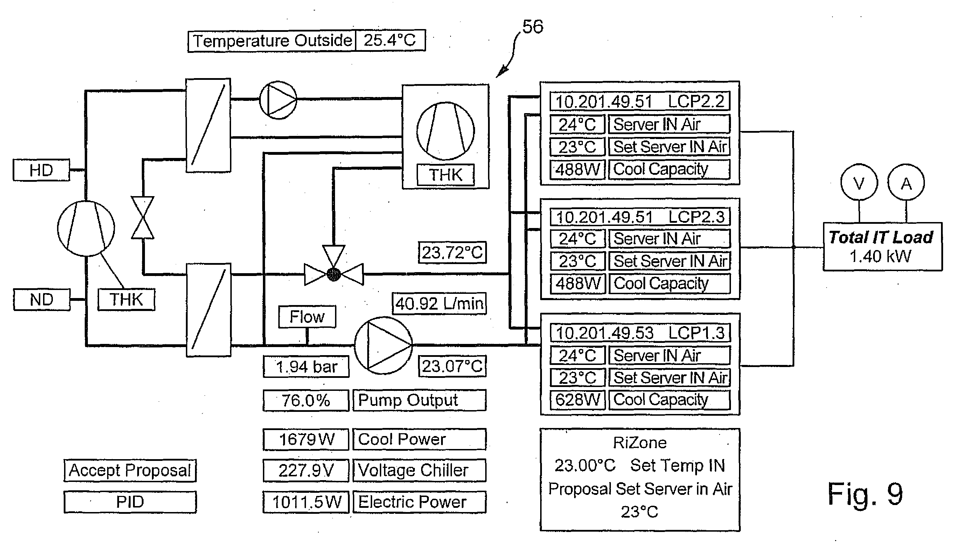

In Fig. 9 ist der Aufbau einer Regelungseinrichtung ähnlich dem linken unteren Teilbild der Fig. 4 näher dargestellt, womit auch das Regelungsverfahren veranschaulicht wird.

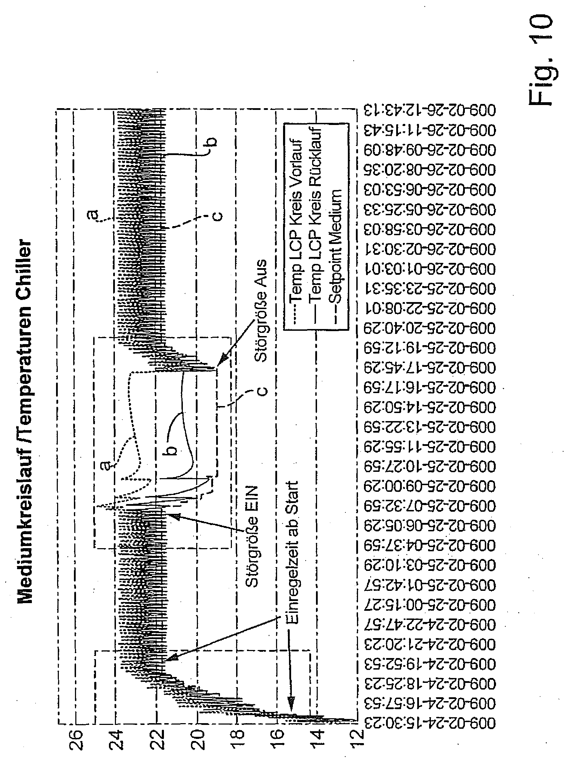

Fig. 10 zeigt Temperaturverläufe einer Vorlauftemperatur (a), einer Rücklauftemperatur (b) und eines Sollwerts der Vorlauftemperatur im Bereich der Rückkühleinrichtung 20. Ab einem Start wird über eine Einregelzeit der Sollwert der Vorlauftemperatur stufenförmig angepasst (c), bis ein stationärer Wert erreicht ist. Ebenfalls wird im Bereich des Auftretens einer Störgröße (Störgröße EIN bis Störgröße AUS) der Sollwert der Vorlauftemperatur adaptiv angepasst (c).

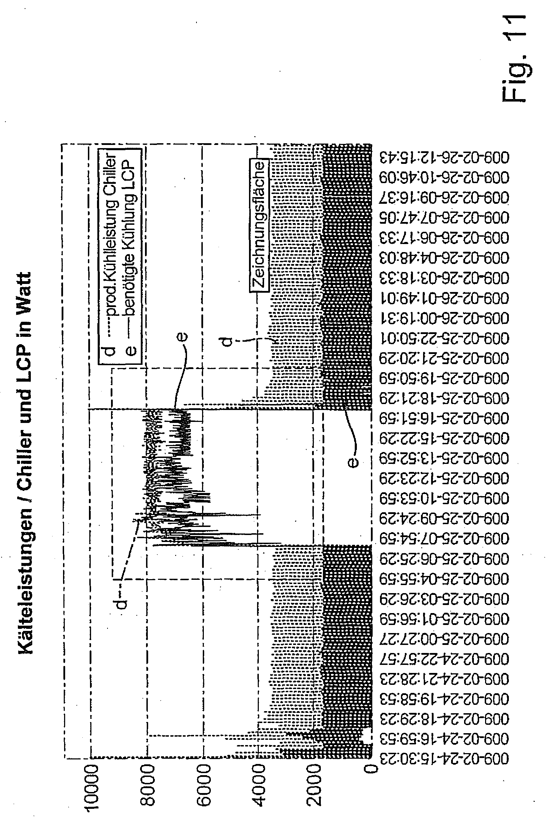

Fig. 11 zeigt Verläufe einer mit der Rückkühleinrichtung produzierten Kühlleistung (d) und einer in den Kühleinheiten benötigten Kühlleistung (e) über der Zeit. Die von der Rückkühleinrichtung 20 produzierte Kühlleistung (d) wird dabei entsprechend der benötigten Kühlleistung (e) angepasst, wie sich insbesondere auch während einer stark geänderten benötigten Kühlleistung zeigt.

Mit den beschriebenen Maßnahmen der Regelung der Kühlleistung bzw. der Zuluft-Temperatur wird den Einbaugeräten bzw. Servern ein lastabhängiger Kühlluftstrom direkt am Gerät zur Verfügung gestellt. Damit wird z. B. bei einer vollständig implementierten IT-Kühlkette eine Gewerke übergreifende Regelung auf die Server-Zuluft-Temperatur verwirklicht. Die IT-Kühlkette umfasst dabei beispielsweise im Serverraum selbst Geräte, die ein Serverrack klimatisieren, wie z. B. die vorstehend beschriebenen Kühleinheiten (LCP = Liquid Cooling Packages), Geräte, die den Raum klimatisieren, wie z. B. die UKS-Geräte, und Geräte, die eine Schrankreihe klimatisieren (z. B. Kühleinheiten und UKS-Geräte). Außerhalb der Serverracks bzw. Serverschränke kann die IT-Kühlkette Geräte umfassen, die das flüssige Kühlmedium, insbesondere Kühlwasser, zur Verfügung stellen, wie z. B. die Rückkühleinrichtung oder Einrichtungen zum Nutzen der Erdkälte oder Absorptionskälte, sowie Geräte, die die Rückkühleinrichtung energieeffizient unterstützen, wie z. B. die Freikühleinrichtung. In der Peripherie der IT-Kühlkette können Gangschottungen, die die Server-Zuluft und Server-Abluft voneinander trennen, Rohre, die z. B. Kaltwassererzeuger und Kaltwasserverbraucher miteinander verbinden, sowie Pumpen, die das Kühlmedium leistungsgerecht zur Verfügung stellen, vorgesehen sein. Unter Verwendung einer Hauptsteuereinrichtung, z. B. mit der zentralen Steuereinheit 70, der alle systemrelevanten Parameter, die maßgeblich die Energieeffizienz der Klimatisierung bestimmen, zur Verfügung stehen, werden alle beteiligten Geräte so geregelt, dass der Kühlleistungsbedarf bzw. die Server-Zuluft-Temperatur konstant auf den vom Anwender gewünschten Wert gehalten wird. Dieser Wert kann je nach Systemzustand dynamisch verändert werden. Das Regelungsverfahren mit dem Regelalgorithmus berücksichtigt dabei, dass alle beteiligten Geräte im energetisch günstigsten Betriebszustand betrieben werden, insbesondere mit geringen Luftmengen, geringen Durchflüssen, möglichst hohem Freikühlungsanteil. Das vollständige System wird dabei hinsichtlich des tatsächlichen Energiebedarfs optimiert.

## Patentansprüche

1. Regelungsverfahren einer Kühlanlage zum Kühlen von in Schaltschränken oder Racks aufgenommenen elektrischen Einbaugeräten mittels diesen zugeordneter Kühleinheiten (11, 12, 13), die von einem mittels einer Kühleinrichtung (20) der Kühlanlage von einer Rücklauftemperatur auf eine Vorlauftemperatur herunter gekühlten flüssigen Kühlmedium durchströmt werden, wobei eine Kühlleistung zum Kühlen der Einbaugeräte nach Vorgabe durch eine Hauptführungsgröße einregelbar ist, wobei die Vorlauftemperatur variabel entsprechend einem Kühlleistungsbedarf im Bereich der Einbaugeräte angepasst wird, wobei aus dem Kühlleistungsbedarf im Bereich der Einbaugeräte die Hauptführungsgröße gebildet wird,
wobei
die Hauptführungsgröße aus einer Einblastemperatur von Einblasluft in dem Bereich der Einbaugeräte bestimmt wird, wobei die Einblastemperatur von der Kühlanlage entsprechend der Hauptführungsgröße auf vorgegebenem Niveau gehalten wird, wobei die Kühlanlage mehrere im Bereich der Einbaugeräte angeordnete Kühleinheiten (11, 12, 13) mit Ventilatoren aufweist, die die Einblasluft erzeugen, und wobei die vorgegebenen Einblastemperaturwerte aller Kühleinheiten (11, 12, 13) auf den kleinsten oder gegebenenfalls gleichen Einblastemperaturwert miteinander verglichen werden und als Einblastemperatur der kleinste Einblastemperaturwert zugrunde gelegt wird, womit die Hauptführungsgröße bestimmt und die Wasservorlauftemperatur angepasst wird.

2. Regelungsverfahren nach Anspruch 1, **dadurch gekennzeichnet, dass** die Kühleinrichtung eine Rückkühleinrichtung (20) aufweist, mit der zumindest zum Teil und/oder zumindest zeitweise die Kühlung des Kühlmediums erfolgt.

3. Regelungsverfahren nach Anspruch 1 oder 2, **dadurch gekennzeichnet, dass** die Hauptführungsgröße aus einer Einblastemperatur von Einblasluft in einer 19"-Einbauebene bestimmt wird.

4. Regelungsverfahren nach Anspruch 1, **dadurch gekennzeichnet, dass** bei einer PID-Regelung als D-Anteil der Regelabweichung eine zeitliche Änderung der Regelabweichung betrachtet wird und dass dann, wenn die zeitliche Änderung eine vorgegebene Schwelle überschreitet, die Vorlauftemperatur angepasst wird.

5. Regelungsverfahren nach einem der vorhergehenden Ansprüche, **dadurch gekennzeichnet, dass** die Vorlauftemperatur dadurch angepasst wird, dass ein Sollwert der Vorlauftemperatur geändert und die Vorlauftemperatur an den geänderten Sollwert der Vorlauftemperatur angepasst wird.

6. Regelungsverfahren nach einem der vorhergehenden Ansprüche, **dadurch gekennzeichnet, dass** die Kühlung des Kühlmediums zumindest zeitweise zum Teil oder vollständig mittels einer Freikühleinrichtung (30) oder einer Erdkälteeinrichtung oder einer Absorptionskälteeinrichtung vorgenommen wird.

## Claims

1. A method for regulating a cooling system for cooling electrical built-in devices housed in control cabinets or racks by means of cooling units (11, 12, 13) assigned thereto, through which a liquid cooling medium, cooled down from a return temperature to a flow temperature by means of a cooling apparatus (20) of the cooling system flows, wherein a cooling power for cooling the built-in devices can be regulated by a primary reference variable according to specification, wherein the flow temperature is variably adjusted according to a cooling power demand in the region of the built-in devices, wherein the primary reference variable is derived from the cooling power demand in the region of the built-in devices, wherein the primary reference variable is determined from a supply air temperature of supply air in the region of the built-in devices, wherein the supply air temperature is maintained at a predefined level according to the primary reference variable by the cooling system, wherein in the region of the built-in devices the cooling system comprises several cooling units (11, 12, 13) having fans which produce the supply air and that the predefined supply air temperature values of all cooling units (11, 12, 13) are compared to each other to determine the smallest or, optionally, the same value, and the supply temperature is based on the smallest supply air temperature value, thus determining the primary reference value and adjusting the water flow temperature.

2. The regulation method of claim 1, **characterized in that** said cooling apparatus comprises a back-flow cooling apparatus (20) for cooling the cooling medium at least partly and/or at least temporarily.

3. The regulation method of claim 1 or 2, **characterized in that** the primary reference variable is determined from a supply air temperature of supply air in a 19" installation level

4. The regulation method of claim 1, **characterized in that** when using a PID control a temporal variation of the control deviation is considered as D part of the control deviation, and, if the temporal variation exceeds a pre-defined threshold, the flow temperature is adjusted.

5. The regulation method of any of the preceding claims **characterized in that** the flow temperature is adjusted by altering a pre-set value of the flow temperature and the flow temperature is adjusted to the altered pre-set value of the flow temperature.

6. The regulation method of any of the preceding claims **characterized in that** cooling of the cooling medium is provided at least temporarily, partly or completely by means of a free-cooling device (30) or an earth cooling device or an absorption cooling device.

## Revendications

1. Procédé de régulation d'une installation de refroidissement pour le refroidissement d'appareils électriques encastrés logés dans des armoires de commande ou des racks au moyen d'unités de refroidissement (11, 12, 13) correspondantes, qui sont traversées par un fluide de refroidissement liquide refroidi, au moyen d'un dispositif de refroidissement (20) de l'installation de refroidissement, d'une température de retour à une température d'aller, une puissance de refroidissement pouvant être régulée pour le refroidissement des appareils encastrés selon les directives par une grandeur de référence principale, la température d'aller étant adaptée de manière variable en fonction des besoins en puissance de refroidissement au niveau des appareils encastrés, la grandeur de référence principale étant formée à partir des besoins en puissance de refroidissement au niveau des appareils encastrés,
la grandeur de référence principale étant déterminée à partir d'une température de soufflage au niveau des appareils encastrés, la température de soufflage étant maintenu par l'installation de refroidissement en fonction de la grandeur de référence principale, l'installation de refroidissement comprenant plusieurs unités de refroidissement (11, 12, 13) disposées au niveau des appareils encastrés, avec des ventilateurs qui produisent l'air soufflé, et les valeurs de température de soufflage prédéterminées de toutes les unités de refroidissement (11, 12, 13) étant comparées entre elles sur la valeur de température de soufflage la plus faible ou, le cas échéant, égale et, en tant que température de soufflage, la valeur de température de soufflage la plus faible est prise pour base, ce qui permet de déterminer la grandeur de référence principale et d'adapter la température d'aller de l'eau.

2. Procédé de régulation selon la revendication 1, **caractérisé en ce que** le dispositif de refroidissement comprend un dispositif de refroidissement de retour (20) avec lequel le refroidissement du fluide de refroidissement a lieu au moins partiellement et/ou au moins temporairement.

3. Procédé de régulation selon la revendication 1 ou 2, **caractérisé en ce que** la grandeur de référence principale est déterminée à partir d'une température de soufflage par de l'air soufflé dans un niveau d'encastrement 19".

4. Procédé de régulation selon la revendication 1, **caractérisé en ce que**, dans une régulation PID, en tant que partie D de l'écart de régulation, une variation temporelle de l'écart de régulation est considérée et **en ce que**, lorsque la variation temporelle dépasse un seuil prédéterminé, la température d'aller est adaptée.

5. Procédé de régulation selon l'une des revendications précédentes, **caractérisé en ce que** la température d'aller est adaptée grâce au fait qu'une valeur de consigne de la température d'aller est modifiée et la température d'aller est adaptée à la valeur de consigne modifiée de la température d'aller.

6. Procédé de régulation selon l'une des revendications précédentes, **caractérisé en ce que** le refroidissement du fluide de refroidissement est effectué temporairement partiellement ou entièrement au moyen d'un dispositif de refroidissement libre (30) ou d'un dispositif de refroidissement de terre ou d'un dispositif de refroidissement par absorption.
